# EUROPEAN PATENT APPLICATION

(11) **EP 1 063 702 A1**
(43) Date of publication of application: **27.12.2000**
(21) Application number: 00110421.5
(22) Date of filing: 16.05.2000
(51) Int. Cl.: H01L 23/525

(54) **Double density fuse structure in a window**

(30) Priority: 21.05.1999 US 316939
(71) Applicant: International Business Machines Corporation, Armonk, NY 10504 (US); Siemens Aktiengesellschaft, 80506 München (DE)
(72) Inventor: Brintzinger, Axel, Fishkill, NY 12524 (US); Kirihata, Toshiaka, Poughkeepsie, NY 12601 (US); Narayan, Chandrasekhar, Hopewell Junction, NY 12533 (US)
(74) Representative: Teufel, Fritz, Dipl.-Phys.

(57) **Abstract**

A fuse structure for a multi-layer semiconductor device. At least two fuses are arranged in a first level of the multi-layer semiconductor device. An electrically conducting structure between the fuses connects the fuses.

## Description

### FIELD OF THE INVENTION

The invention relates to a fuse array structured for use in semiconductor devices and processes for forming the fuse structure.

### BACKGROUND OF THE INVENTION

Fuses are included in semiconductor devices to help protect the devices and to provide a means of activating redundant elements to enhance product yield. Metal fuses typically are included in integrated circuits to reroute circuit features during and after wafer manufacturing processes. A laser blown fuse is typically accessed through a window opened in the final passivation terminal via dielectric. The laser power and spot location must be carefully controlled to minimize damage to adjacent fuses and to the underlayer structures including the semiconductor substrate.

In modern microelectronics, often, a rather large number of fuses must be incorporated into a rather small space to provide redundancy without an area overhead. For example, as memory capacity increases in memory devices having similar or reduced sized, the number of fuses increases.

According to one example, in currently utilized DRAM device design, the fuses and associated circuitry typically consume an area of about 3% to about 5% of the total chip area. As device sizes continue to shrink, future generations of memory chips may be negatively impacted by the amount of area necessary for fuse structures. According to estimations, some DRAM devices e.g. 1Gb DRAMS may require up to about 30,000 fuses.

Accordingly, ways are being sought to increase fuse density. One way of accomplishing an increase in fuse density is by reducing fuse pitch, without a penalty in area needed on a chip.

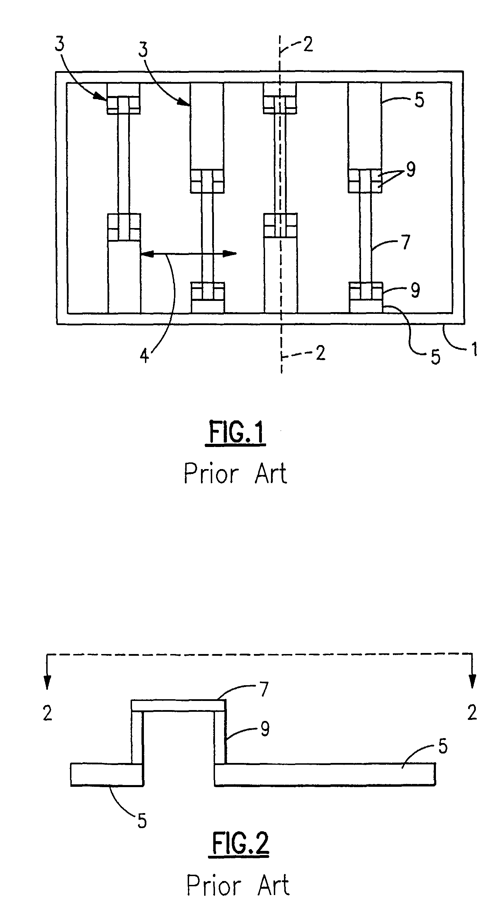

Fig. 1 illustrates an example of a fuse structure that is currently utilized for laser blown fuses. The fuse structure illustrated in Fig. 1 is being seen through the terminal via window 1. The structure illustrated in Fig. 1 includes four fuses 3. To protect the wiring of a fuse that interconnects the fuse with the surrounding devices, connectors of the fuses may be on one metal level below the actual fuse.

Each fuse illustrated in Fig. 1 includes a connector 5. Also, each fuse structure includes the portion of the fuse 7 that is destroyed as the fuse blows. The blown portion 7 is connected to the connector by vias 9. The embodiment of the known fuse structure illustrated in Fig. 1 includes a fuse pitch 4 of about 3.2 µm.

Fig. 2 illustrates a cross-sectional view of one of the fuses illustrated in Fig. 1. The portion of the fuse to be blown 7 is seen arranged in one metal level in Fig. 2. The vias 9 connect the blowing portion 7 to the connectors 5. Fig. 2 clearly illustrates the arrangement of the portion of the fuse to be blown 7 in one metal level and the connectors 5 in a lower metal level.

### SUMMARY OF THE INVENTION

In order to provide a fuse structure that permits fuses to be much more densely arranged, aspects of the present invention provide a fuse structure for a multi-layer semiconductor device. The fuse structure includes at least two fuses arranged in a first level of the multi-layer semiconductor device. An electrically conducting structure extending between the fuses connects the fuses.

Other aspects of the present invention provide a method for forming fuses for multi-layer semiconductor device. The method includes forming electrically conducting connector level. Vias are formed extending from the connector level. At least two fuses are formed connected to the vias and to each other through the connector level.

Still other objects and advantages of the present invention will become readily apparent by those skilled in the art from the following detailed description, wherein it is shown and described only the preferred embodiments of the invention, simply by way of illustration of the best mode contemplated of carrying out the invention. As will be realized, the invention is capable of other and different embodiments, and its several details are capable of modifications in various obvious respects, without departing from the invention. Accordingly, the drawings and description are to be regarded as illustrative in nature and not as restrictive.

### BRIEF DESCRIPTION OF THE DRAWINGS

The above-mentioned objects and advantages of the present invention will be more clearly understood when considered in conjunction with the accompanying drawings, in which:
Fig. 1 represents an overhead view of one example of a known fuse structure for use in semiconductor devices;
Fig. 2 represents a cross-sectional view of one fuse in the fuse structure illustrated in Fig. 1 taken along the line 2-2 in Fig. 1;
Fig. 3 represents an overhead view of an embodiment of a fuse structure according to the present invention;
Fig. 4 represents a cross-sectional view of two fuses in the structure shown in Fig. 3 taken along the line 4-4 in Fig. 3;
Fig. 5 represents a cross-sectional view of an alternative fuse structure to the fuse structure shown in Fig. 4;
Fig. 6 represents a cross-sectional view of an alternative variation of the embodiment illustrated in Fig. 5;
Fig. 7 represents an overhead view of an example of a known fuse structure; and
Fig. 8 represents an overhead view of an embodiment of a fuse structure according to the present invention.

### DETAILED DESCRIPTION OF THE INVENTION

The present invention provides a fuse structure and a method for creating the fuse structure that permits a great increase in fuse density without reducing fuse pitch. In fact, according to the present invention, fuse density may be doubled without reducing fuse pitch. In addition to increasing fuse density, the present invention offers the advantage of a large process window because fuse density can be increased without substantial process alteration.

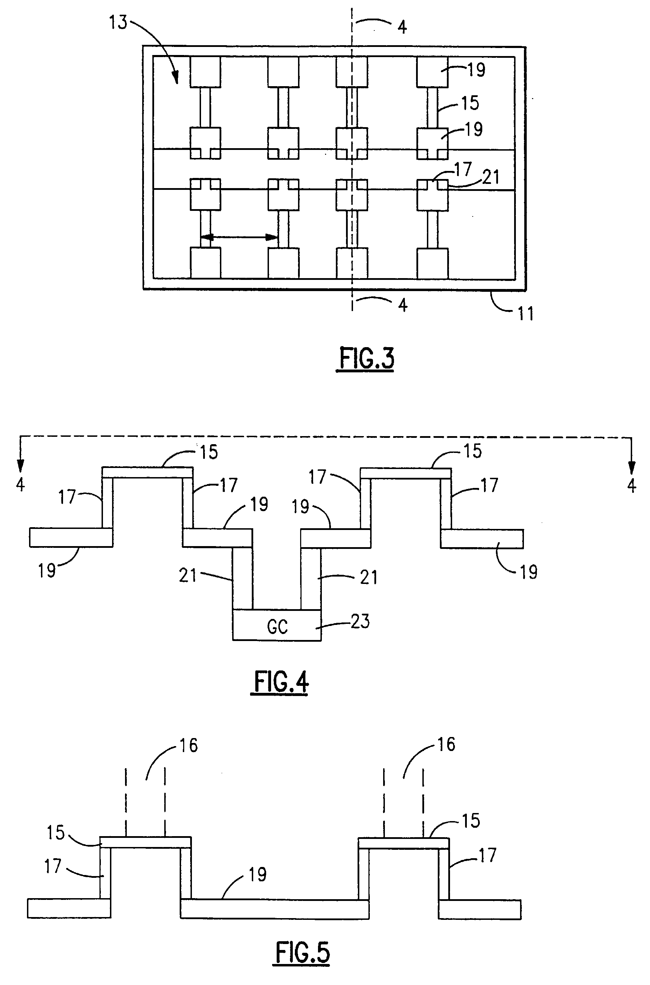

Fig. 3 illustrates an overhead view of one embodiment of a fuse structure according to the present invention. As in the embodiment illustrated in Fig. 1, the embodiment illustrated in Fig. 3 includes fuses formed in a terminal via window 11. As can be seen in Fig. 3, in a similar size terminal via window, eight fuses may be formed as opposed to the four in a structure illustrated in Fig. 1. Thus, the present invention may permits a doubling of fuse density.

Each fuse 13 in the embodiment illustrated in Fig. 3 includes a portion 15 that is actually blown. This blown portion 15 is arranged at a first metal level, M1. As with all the other portions of the fuse, vias, and connectors, the portion 15 that is actually blown is typically made from an electrically conducting material. The blown portion may be made from a variety of materials, such as aluminum, copper, polycrystalline silicon, tungsten, among others.

Each blown portion 15 may be connected at each end to connector vias 17 that connect the fuse to connectors 19. The connectors 19 may provide connections between the fuses, through the vias, to other portions of the semiconductor device including the fuses. Typically, the connectors are arranged in a different level of a multi-layer structure as compared to the blowing portion 15.

The fuse structure according to the present invention may also include a gate conductor 23 to which all the fuses are connected. The embodiment of the gate conductor illustrated in Fig. 3 is perpendicular to the direction of the fuses. The gate conductor may be connected to a ground that is common to all of the existing fuse circuitry. Providing a common contact for all of the fuses may avoid interaction with a laser beam.

Fig. 4 illustrates a cross-sectional view of the embodiment of the present invention illustrated in Fig. 3.

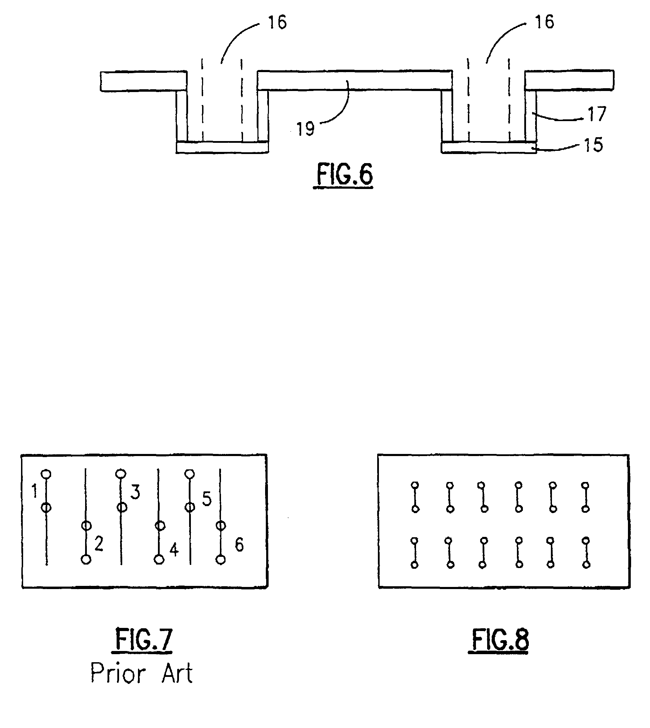

Fig. 5 illustrates an alternative to the embodiment of the present invention illustrated in Figs. 3 and 4. The embodiment in Fig. 5 includes blown portion 15 and first connection level vias 17 connecting the fuse blowing portion 15 to the connectors 19 in the metal level below the level that the fuse blowing portion 15 are arranged in. This structure might be desirable in the event that resistance in the gate contact stack is too high. As an alternative, the structure illustrated in Fig. 5 could be arranged oppositely, as the structure illustrated in Fig. 6.

Figs. 7 and 8 provide a comparative illustration of the fuse density in a known structure and a structure according to the present invention. Along these lines, Fig. 7 illustrates a known fuse structure. On the other hand, Fig. 8 illustrates a fuse structure according to the present invention. As can be seen by comparing the structures illustrated in Figs. 7 and 8, the present invention permits formation of fuses with a much greater density as compared to the prior art.

The structures illustrated in Figs. 3-6 and 7 could be formed by a process such as that described below or by any known process, including standard photolithographic processes.

Regardless of the embodiment, all of the fuses according to the present invention may be provided inside a single opening in passivation layer(s) of a semiconductor device structure.

The foregoing description of the invention illustrates and describes the present invention. Additionally, the disclosure shows and describes only the preferred embodiments of the invention, but as aforementioned, it is to be understood that the invention is capable of use in various other combinations, modifications, and environments and is capable of changes or modifications within the scope of the inventive concept as expressed herein, commensurate with the above teachings, and/or the skill or knowledge of the relevant art. The embodiments described hereinabove are further intended to explain best modes known of practicing the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments.

## Claims

1. A fuse structure for a multi-layer semiconductor device, comprising:
at least two fuses arranged in a terminal via opening in a first level of the multi-layer semiconductor device; and
an electrically conducting structure between the fuses to connect the fuses.

2. The fuse structure according to claim 1, further comprising:
at least one pair of vias associated with each fuse for connecting ends of the fuses to the electrically conducting structure.

3. The fuse structure according to claim 2, wherein the structure for electrically connecting the at least two fuses includes an electrically conducting connector arranged in a second level of the multi-layer semiconductor device, and wherein the vias connect the at least two fuses to the electrically conducting connector.

4. The fuse structure according to claim 3, wherein the structure for electrically connecting the at least two fuses further includes a gate conductor common at least to the at least two fuses, wherein the common gate conductor electrically connects the connector and is arranged in a third level of the multi-layer structure.

5. The fuse structure according to claim 3, further comprising:
at least one via for connecting the common gate conductor to the electrically conducting connector.

6. The fuse structure according to claim 3, further comprising:
a plurality of fuses, wherein the gate conductor is common to all of the fuses.

7. The fuse structure according to claim 1, wherein the fuse structure is arranged in a terminal via window of the multi-layer semiconductor structure.

8. The fuse structure according to claim 1, wherein the fuses are laser blown fuses.

9. A method for forming fuses for a multi-layer semiconductor device, the method comprising the steps of:
forming an electrically conducting connector level;
forming vias extending from the connector level; and
forming at least two fuses connected to the vias and to each other through the connector level.

10. The method according to claim 9, further comprising the steps of:
forming a gate conductor common to the fuses; and
forming vias extending from the gate conductor for connecting the common gate conductor to the connector level.

11. The method according to 9, wherein the fuse structure is formed in a terminal via window of the multi-layer semiconductor structure.
